(19) Europäisches Patentamt
European Patent Office
Office européen des brevets

(11) **EP 1 941 614 B1**

(12) **EUROPÄISCHE PATENTSCHRIFT**

(45) Veröffentlichungstag und Bekanntmachung des Hinweises auf die Patenterteilung:
**20.02.2019 Patentblatt 2019/08**

(21) Anmeldenummer: **06792337.5**

(22) Anmeldetag: **30.09.2006**

(51) Int Cl.:
*H03K 17/97* *(2006.01)*      *H03K 17/95* *(2006.01)*
*B62B 3/06* *(2006.01)*

(86) Internationale Anmeldenummer:
**PCT/EP2006/009512**

(87) Internationale Veröffentlichungsnummer:
**WO 2007/048481 (03.05.2007 Gazette 2007/18)**

(54) **FAHRSCHALTER ZUR STEUERUNG EINES FAHRANTRIEBS EINES KRAFTGETRIEBENEN FLURFÖRDERZEUGS**

CONTROLLER FOR CONTROLLING A DRIVE MECHANISM OF A POWERED INDUSTRIAL TRUCK

COMBINATEUR DE PUISSANCE DESTINÉ À COMMANDER UN ENTRAINEMENT D'UN CHARIOT DE MANUTENTION ENTRAINÉ PAR LA FORCE

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **24.10.2005 DE 202005016726 U**

(43) Veröffentlichungstag der Anmeldung:
**09.07.2008 Patentblatt 2008/28**

(60) Teilanmeldung:
**13177157.8 / 2 658 128**

(73) Patentinhaber: **REMA Lipprandt GmbH & Co. KG
53359 Rheinbach (DE)**

(72) Erfinder: **STANDKE, Kurt
53177 Bonn (DE)**

(74) Vertreter: **Kluin, Jörg-Eden et al
KLUIN Patent
Postfach 18 03 54
40570 Düsseldorf (DE)**

(56) Entgegenhaltungen:
**EP-A1- 0 900 719      DE-U1- 20 004 887
US-B1- 6 276 485**

**Beschreibung**

Die Erfindung betrifft einen Fahrschalter zur Steuerung des Fahrantriebs eines kraftgetriebenen Flurförderzeugs. Aus der EP 1 180 473 A1 ist ein Fahrschalter bekannt, welcher einen Hall-Sensor sowie zwei Permanentmagnete auf einem kreissegmentförmig ausgebildeten Magnetträger umfasst. Der Magnetträger besitzt zwischen den Permanentmagneten eine Aussparung, in welche der Hall-Sensor aufrecht stehend hineinragt, so dass er von dem Magnetfeld, das von den mit ungleichnamigen Polen einander zugewandten Permanentmagneten erzeugt wird, durchflutet wird. Der Magnetträger ist derart mit einem von einem Bediener zu betätigenden Fahrschaltergriff verbunden, dass er bei einer Betätigung des Fahrschaltergriffs derart relativ zum Hall-Sensor verschwenkt wird, dass entweder der eine oder der andere Permanentmagnet näher an den Hall-Sensor herangelangt, so dass sich je nach Größe der Betätigung und damit der Verschwenkung des Magnetträgers das Magnetfeld, von dem der Hall-Sensor durchflutet wird, ändert, wodurch eine entsprechend dem Verschwenkungswinkel des Magnetträgers unterschiedliche Hall-Spannung induziert wird, welche als Signal zur Ansteuerung des Motors des Flurförderzeugs dient.

In der Praxis hat sich gezeigt, dass dieser Fahrschalter störanfällig ist. So kann sich die von dem Hall-Sensor erzeugte Hall-Spannung, die der Mittelstellung des Magnetträgers entspricht und somit als Steuersignal "neutral", d.h. Stillstand des Flurförderzeugs interpretiert werden soll, ändern, wenn beispielsweise die Position des Hall-Sensors zwischen dem Permanentmagneten dejustiert wird, was beispielsweise durch eine äußere Stoßeinwirkung hervorgerufen werden kann. Bei dem Fahrschalter ist daher ein Mikroschalter vorgesehen, der von dem Magnetträger in seiner Mittel-, d.h. Neutralstellung betätigt wird. Der Mikroschalter ist als Sicherheitsschalter angelegt, d.h. er verhindert ein Fahrsignal unabhängig von der aktuellen Hall-Spannung.

Zwar wird auf diese Weise verhindert, dass sich bei einer Dejustierung des Hall-Sensors das Flurförderzeug trotz Neutralstellung der Fahrschaltergriffe in Bewegung setzt, jedoch führt die Dejustierung zu einer Änderung der Abhängigkeit der Hall-Spannung von der Fahrschaltergriffstellung, so dass beispielsweise das Flurförderzeug bei einer Verlagerung des Magnetträgers aus seiner Mittelstellung nach Deaktivierung des Sicherheitsschalters sprunghaft oder zunächst nicht anfährt, je nachdem, in welche Richtung sich die Abhängigkeit der Hall-Spannung von der Fahrschaltergriffstellung durch die Dejustierung verändert hat.

Ferner kann bei starker Dejustierung des Hall-Sensors ein wiederholtes einseitiges Anschlagen eines Magneten auf eine Oberfläche des Hall-Sensors auftreten, welches eine wiederholte Verbiegung der Anschlusskontakte des Hall-Sensors verursacht. Dies kann nach einer Vielzahl von Betätigungen des Fahrschalters zu Ermüdungsbrüchen der Anschlusskontakte führen. Für den Bediener kann dies sehr gefährlich werden, da das dann von der Elektronik generierte Signal je nach Auslegung derselben dem Sollwert "volle Fahrgeschwindigkeit voraus" oder "volle Fahrgeschwindigkeit zurück" entspricht und - sofern keine weiteren Sicherheitssysteme vorhanden sind - sich das Fahrzeug abrupt in Bewegung setzt.

Darüber hinaus unterliegt der Mikroschalter aufgrund seiner mechanischen Arbeitsweise einem gewissen Verschleiß, so dass auch dessen sichere Funktion nicht über einen unbegrenzten Zeitraum gewährleistet ist. In der Praxis hat sich gezeigt, dass der Mikroschalter mit zunehmender Anzahl von Betriebszyklen erst immer später, d.h. bei größeren Schwenkwinkeln des Magnetträgers auslöst, was wiederum zu einem sprunghaften Anfahren des Flurförderzeugs führt.

Aus der US 6,276,485 ist ein Fahrschalter zur Steuerung des Fahrantriebs eines kraftgetriebenen Flurförderzeugs bekannt, der eine Mehrzahl von Hall-Sensoren, die einen seitlichen Abstand voneinander aufweisen, sowie eine Quelle magnetischer Feldlinien umfasst. Diese Quelle ist bei Betätigung des Fahrschalters relativ zu den Hall-Sensoren verlagerbar, so dass sich die magnetische Flussdichte in den Hall-Sensoren ändert. Dabei werden die Hall-Sensoren nacheinander von den magnetischen Feldlinien durchsetzt, so dass eine nachgeschaltete Elektronik anhand dessen, in welchem der Hall-Sensoren gerade ein Signal erzeugt wird, auf die Fahrschalterstellung schließt und den Fahrantrieb entsprechend ansteuert.

Der Erfindung liegt daher die Aufgabe zugrunde, einen Fahrschalter zu schaffen, mit dem eine zuverlässigere Steuerung des Fahrantriebs eines Flurförderzeugs auch über eine große Anzahl von Betätigungszyklen des Fahrschalters sichergestellt ist.

Diese Aufgabe wird durch den in Anspruch 1 wiedergegebenen Fahrschalter gelöst.

Der erfindungsgemäße Fahrschalter umfasst zwei Hall-Sensoren, die einen seitlichen Abstand voneinander aufweisen, sowie eine Quelle magnetischer Feldlinien, die bei Betätigung des Fahrschalters relativ zu den Hall-Sensoren verlagerbar ist, so dass sich die magnetische Flussdichte in den Hall-Sensoren ändert. Es ist eine Datenverarbeitungsanlage vorgesehen, von welcher die Hall-Spannungen der beiden Hall-Sensoren analog zur Steuerung des Fahrantriebs verwendet werden. Durch die Verwendung von zwei Hall-Sensoren kann das Fahrsignal für eine Richtung, beispielsweise vorwärts, von dem einen Hall-Sensor erzeugt werden, wobei das Signal des anderen Hall-Sensors als Plausibilitätscheck und damit zur Sicherheitsüberprüfung verwendet wird. Dementsprechend wird das Fahrsignal für die andere Fahrtrichtung, beispielsweise rückwärts, von dem anderen Hall-Sensor erzeugt, wobei das Signal des einen Sensors dann als Plausibilitätscheck und damit der Sicherheitsüberprüfung dient.
Durch diese Ausgestaltung weist der erfindungsgemäße Fahrschalter gegenüber dem Stand der Technik unter anderem die folgenden Vorteile auf:

Die Hall-Sensoren können so in dem Magnetfeld angeordnet werden, dass sich bei der durch Betätigung des Fahrschalters ändernden magnetischen Flussdichte die Hall-Spannung des einen Hall-Sensors nahezu linear mit der Betätigung des Fahrschalters in einer Fahrtrichtung ändert, diejenige des anderen Hall-Sensors dementsprechend bei Betätigung des Fahrschalters in der anderen Fahrtrichtung ebenfalls nahezu linear ändert. Beide Hall-Sensoren können mit anderen Worten in einem Bereich betrieben werden, in dem ihr Ausgangssignal - die Hall-Spannung - analog zur Ansteuerung des Motors des Flurförderzeugs verwendet werden kann. Die Hall-Spannung des jeweils anderen Hall-Sensors, der nicht im nahezu linearen Bereich betrieben wird, kann dann einerseits zur Erkennung der Fahrtrichtung, andererseits der Sicherheitsüberprüfung dienen, indem eine Routine vorgesehen wird, die den Motor des Flurförderzeugs stillsetzt, wenn Hall-Spannungen von den beiden Hall-Sensoren erzeugt werden, die in einem nicht zu erwartenden Verhältnis zueinander stehen.

Besonders bevorzugt ist eine Ausführungsform des Fahrschalters, bei der die Hall-Sensoren auf einer Seite einer Platine flach angeordnet sind. Durch diese Maßnahme wird aufgrund der gegenüber einer stehenden, aus der EP 1 180 473 A1 bekannten Anordnung der Hall-Sensoren deren Empfindlichkeit gegen äußere mechanische Einflüsse wesentlich reduziert, da eine mechanisch erheblich stabilere Befestigung der Hall-Sensoren auf der Platine möglich ist. Die magnetische Flussdichte durch die Hall-Sensoren kann wesentlich erhöht werden, wenn - wie besonders bevorzugt - auf der den Hall-Sensoren gegenüberliegenden Seiten der Platine ein Joch zum Leiten der magnetischen Feldlinien vorgesehen ist. Durch Erhöhung der Flussdichte wird bewirkt, dass der Fahrschalter unempfindlicher gegen äußere, magnetische Einflüsse ist.

Grundsätzlich kann die Quelle magnetischer Feldlinien in beliebiger Weise, die eine Änderung der Flussdichte durch die Hall-Sensoren bei Betätigung des Fahrschalters bewirkt, ausgestaltet sein. Wegen der Einfachheit des Aufbaus und der Störunanfälligkeit ist es jedoch bevorzugt, als Quelle magnetischer Feldlinien zwei in einem seitlichen Abstand voneinander angeordnete Permanentmagnete vorzusehen, die - besonders bevorzugt - oberhalb der Hall-Sensoren angeordnet sind, eine umgekehrte Polarität aufweisen, wobei sich die Polachsen etwa senkrecht zur Platine erstrecken, und in einer zur Platine etwa parallelen Ebene bei Betätigung des Fahrschalters verlagerbar sind. Versuche haben gezeigt, dass bei dieser Anordnung bei einer Verlagerung der Permanentmagneten in einem Kreisbogen um ± 30° um eine Neutralstellung eine Änderung der Hall-Spannungen in den beiden Hall-Sensoren im annähernd linearen Bereich erzeugbar ist. Ferner besteht bei dieser Anordnung im Gegensatz zur Anordnung nach der EP 1 180 473 A1, bei der sich der Hall-Sensor zwischen den Magneten befindet, nicht mehr die Gefahr, dass es zu einer mechanischen Kollision der Magnete mit den Hall-Sensoren kommt, was die Betriebssicherheit des erfindungsgemäßen Fahrschalters abermals erhöht.

Die magnetische Flussdichte durch die Hall-Sensoren kann - was bevorzugt ist - nochmals erhöht werden, wenn die Permanentmagnete auf ihrer der Platine fort weisenden Seite über ein Joch zum Leiten der magnetischen Feldlinien verbunden sind.

Die Permanentmagnete sind - wie bereits oben erwähnt - vorzugsweise auf einer Kreisbahn verlagerbar, da Fahrschaltergriffe regelmäßig drehbetätigt werden und eine einfache Übertragung der Drehbetätigung auf einen die Permanentmagnete auf einer Kreisbahn verlagernden Magnetträger möglich ist. Der erfindungsgemäße Fahrschalter weist eine Datenverarbeitungseinrichtung auf, welche die von den Hall-Sensoren erzeugten, elektrischen Signale aufnimmt und den Signalen eine Fahrgeschwindigkeit und Fahrtrichtung zuordnet, wobei zur Bestimmung der Fahrgeschwindigkeit das Signal eines Hall-Sensors Verwendung findet, bei welchem sich die magnetische Flussdichte in einem Bereich befindet, in dem das elektrische Signal eine Funktion der magnetischen Flussdichte ist, bevorzugt im Falle von verlagerten Permanentmagneten sich zumindest nahezu linear mit der Verlagerung der Permanentmagnete ändert. Besonders bevorzugt ist es, wenn der Fahrschalter des weiteren eine Speicheranordnung umfasst, in welcher die zu erwartenden Sollwerte für die elektrischen Signale der Hall-Sensoren in Abhängigkeit der Fahrschalterstellung gespeichert sind und eine Einrichtung zum Vergleich der Sollwerte mit den von den Hall-Sensoren erzeugten Istwerten vorgesehen ist, die bei einem nicht zu erwartenden Verhältnis der Istwerte der Signale der beiden Hall-Sensoren den Fahrschalterzustand "neutral" bewirkt. Aufgrund dieser Speicheranordnung wird bei dem erfindungsgemäßen Fahrschalter in bevorzugter Weise eine Sicherheitsschaltung ausgebildet, die sicherstellt, dass das Flurförderzeug bei unerwarteten Signalverhältnissen, die auf einen Fehler in dem Fahrschalter hindeuten, stillgesetzt wird. Da diese Sicherheitsschaltung vollständig elektronisch arbeitet, unterliegt sie im Gegensatz zum Stand der Technik keinem mechanischen Verschleiß.

Der Fahrschalterzustand "neutral" wird ebenfalls bewirkt, wenn die Einrichtung zum Vergleich des Soll- und Istwertes solche Istwerte erfasst, die das für die Neutralstellung zu erwartende Signalverhältnis aufweisen.

Ein bevorzugtes Ausführungsbeispiel des erfindungsgemäßen Fahrschalters soll nachfolgend anhand der beigefügten Zeichnungen im einzelnen beschrieben werden. Es zeigen:

Fig. 1      - schematisch - die Anordnung der Hall-Sensoren und der Permanentmagnete in einer Aufsicht;

Fig. 2    - ebenfalls schematisch - die Anordnung gemäß Fig. 1 in einer Seitenansicht (Ansicht A in Fig. 1);

Fig. 3    die Hall-Spannungen der beiden Hall-Sensoren in Abhängigkeit der Winkelauslenkung des Magnetträgers aus der Neutralstellung sowie

Fig. 4    - schematisch - den Ablauf der Datenverarbeitung in der Datenverarbeitungseinrichtung.

Das dargestellte Ausführungsbeispiel des erfindungsgemäßen Fahrschalters umfasst einen ersten Hall-Sensor 1 und einen zweiten Hall-Sensor 2, die auf einem Kreisbogen angeordnet mit seitlichem Winkelabstand flach auf einer Seite einer Platine 4 befestigt sind. Oberhalb der Platine 4 sind zwei Permanentmagnete 3, 6 an einem Joch 5 angebracht. Die Permanentmagnete 3 und 6 sind so ausgerichtet, dass ihre Polachsen parallel, jedoch in umgekehrter Richtung verlaufen. Das Joch 5 dient einerseits als Magnetträger, andererseits zum gebündelten Leiten der magnetischen Flusslinien von einem Permanentmagnet in den anderen.

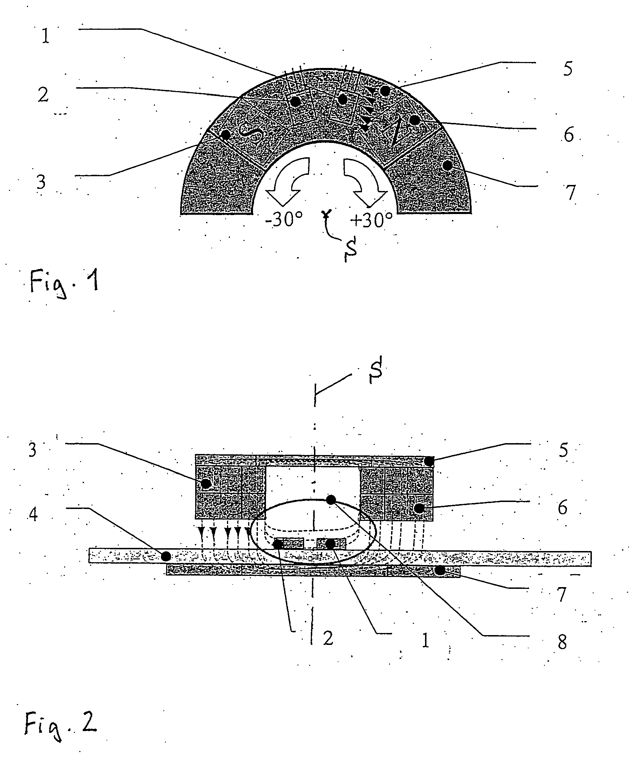

Das Joch 5 ist teilringförmig gestaltet und aus seiner in Fig. 1 und 2 dargestellten Mittellage um etwa $\pm$ 30° um eine Achse S verlagerbar.

Auf der den Hall-Sensoren 1, 2 gegenüberliegenden Seite der Platine 4 ist ebenfalls ein Joch 7 angeordnet, welches ebenfalls teilringförmig ausgebildet ist und sich über einen etwa 180° Winkelbereich derart erstreckt, dass das Joch 5 bei der Winkelauslenkung von $\pm$ 30° stets von dem Joch 7 unterdeckt wird, so dass die magnetischen Feldlinien stets durch das Joch 7 gebündelt werden und somit ein geschlossenes, stabilisiertes Magnetfeld, dessen Feldlinien die Hall-Sensoren durchdringen, gebildet wird. Das geschlossene Magnetfeld ist in Fig. 2 durch das mit 8 bezeichnete Oval symbolisiert.

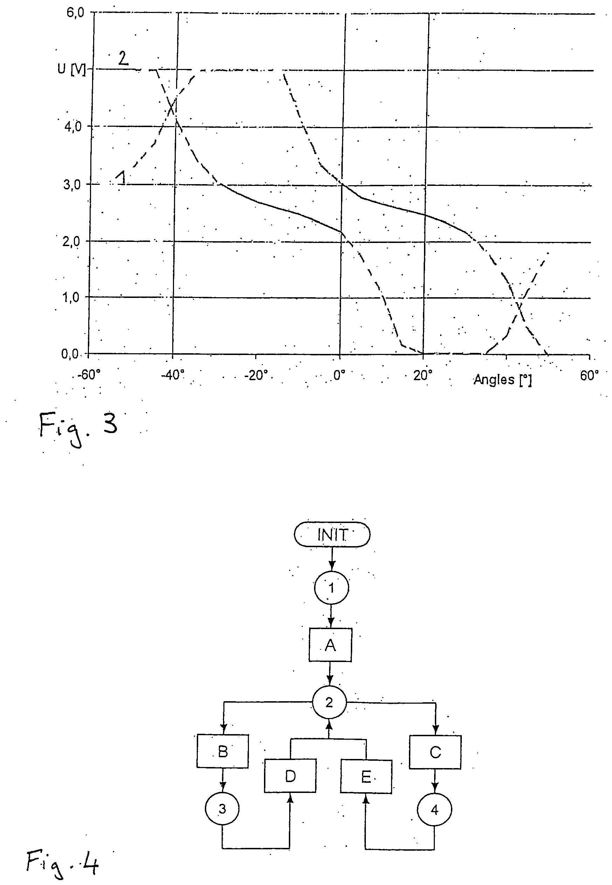

Die in den Hall-Sensoren 1, 2 aufgrund des Magnetfeldes 8 erzeugten Hall-Spannungen sind in Abhängigkeit von der Winkelauslenkung des Jochs 5 aus der in Fig. 1 und 2 dargestellten, mit 0° bezeichneten Neutralstellung in Fig. 3 dargestellt. Wie erkennbar ist, zeigt die Abhängigkeit der Hall-Spannung des Hall-Sensors 1 im Bereich von 0 bis +30° einen etwa linearen Verlauf zwischen 3 und 2 V. Dieser Bereich der Kurve ist durchgezogen dargestellt. Entsprechend zeigt die Hall-Spannung des Hall-Sensors 2 im Bereich von 0 bis - 30° eine nahezu lineare Abhängigkeit vom Winkel zwischen 2 und 3 V. Dieser Bereich ist ebenfalls durchgezogen dargestellt. Aufgrund dieser nahezu linearen Abhängigkeit werden die Hall-Spannungen von einer in der Zeichnung nicht dargestellten Datenverarbeitungseinrichtung analog zur Ansteuerung des Motors des Flurförderzeugs im Sinne der Vorgabe der Sollgeschwindigkeit verwendet. Die analogen Spannungs-Ausgangssignale werden vorzugsweise durch einen A/D-Wandler konvertiert, aufbereitet und dann in digitaler Form, beispielsweise seriell, über CAN Bus etc. an die Motorsteuerung weitergeleitet. Der Wert der Hall-Spannung des jeweils anderen Hall-Sensors, der sich in dem nahezu linearen Bereich nahezu in einem Plateau befindet, wie dies in Fig. 3 gestrichelt dargestellt ist, wird von der Datenverarbeitungseinrichtung zur Plausibilitätsüberprüfung in dem Sinne verwendet, dass der Motor des Flurförderzeugs stillgesetzt wird, wenn die Hall-Spannungswerte über gewisse Fehlertoleranzen hinaus nicht den erwarteten Sollwerten entsprechen. Hierzu wird von der Datenverarbeitungseinrichtung überprüft, ob der Wert der Hall-Spannung des jeweils anderen Hall-Sensors ober- oder unterhalb eines bestimmten Schwellenwerts liegt und in Abhängigkeit dessen ein Signal 0 oder 1 erzeugt. Der Motor des Flurförderzeugs wird nur dann mit einem Fahrsignal angesteuert, wenn der Wert der Hall-Spannung des jeweils anderen Hall-Sensors auf der erwarteten Seite der Schwelle liegt.

Eine bevorzugte Ausgestaltung der Datenverarbeitungseinrichtung, mit der die Hall-Sensoren 1, 2 verbunden sind, erzeugt die folgenden Ausgangssignale:

-   Motorsteuerung: Analoges Signal von dem jeweiligen Hall-Sensor ohne Richtungsinformation

-   Neutral: Digitales Signal, das erzeugt wird, wenn das für die Neutralstellung des Magnetträgers charakteristische Verhältnis der Hall-Spannungen der Hall-Sensoren 1 und 2 erfasst wird

-   Vorwärts: Digitales Signal über die Zielrichtung, erzeugt anhand des erfassten Verhältnis der Hall-Spannungen der Hall-Sensoren 1 und 2;

-   Rückwärts: Digitales, in entsprechender Weise erzeugtes Signal.

Die folgenden Werte werden von der Datenverarbeitungseinrichtung verwendet:

-   V1: Hall-Spannung des Hall-Sensors 1 bei voller Auslenkung des Magnetträgers im positiven Drehsinne, hier bei + 30°

-   V2: Hall-Spannung des Hall-Sensors 1 bei maximaler Auslenkung des Magnetträgers im negativen Drehsinne, hier bei - 30°

- V3: Hall-Spannung des Hall-Sensors 1 am Rand der Neutralstellung im positiven Drehsinne

- V4: Hall-Spannung des Hall-Sensors 1 am Rand der Neutralstellung im negativen Drehsinne

- V11: Hall-Spannung des Hall-Sensors 2 bei voller Auslenkung des Magnetträgers im positiven Drehsinne, hier bei + 30°

- V12: Hall-Spannung des Hall-Sensors 2 bei maximaler Auslenkung des Magnetträgers im negativen Drehsinne, hier bei - 30°

- V13: Hall-Spannung des Hall-Sensors 2 am Rand der Neutralstellung im positiven Drehsinne

- V14: Hall-Spannung des Hall-Sensors 2 am Rand der Neutralstellung im negativen Drehsinne.

Die Datenverarbeitungseinrichtung ist des weiteren so gestaltet, dass in der Neutralstellung die Ausgangssignale passiv sind, d.h. Motoransteuerung = 0, Neutralsignal = 1, Vorwärtssignal = 0, Rückwärtssignal = 0. Lediglich wenn der Magnetträger aus der Neutralposition verlagert und kein Störzustand detektiert werden schaltet die Datenverarbeitungseinrichtung in den aktiven Modus um.

Der Ablauf der Verarbeitung der Daten mittels der Datenverarbeitungseinrichtung ist in Fig. 4 dargestellt. In einem ersten Schritt A wird überprüft, ob sich die Hall-Spannung des Hall-Sensors 1 im Bereich zwischen V4 und V3 und der Wert der Hall-Spannung 2 im Bereich zwischen V14 und V13 befinden. Ist dies nicht der Fall, so wird überprüft, ob die Hall-Spannung des Hall-Sensors 1 größer V3 und die Hall-Spannung des Hall-Sensors 2 größer V13 ist. Ferner wird überprüft, ob die Hall-Spannung des Hall-Sensors 1 kleiner als V4 und die Hall-Spannung des Hall-Sensors 2 größer V14 ist. Sollte einer der vorstehenden Zustände festgestellt werden, so befinden sich die Ausgänge der Datenverarbeitungseinrichtung im Passivstatus, d.h. der Motor des Flurförderzeugs wird nicht angesteuert. Erst wenn keines der vorstehenden Hall-Spannungsverhältnisse erfasst wird, die entweder auf eine Neutralstellung des Magnetträgers oder auf einen Fehlerzustand hin deuten, wird für den Fall, dass die Spannung des Hall-Sensors 1 kleiner V3 oder die Hall-Spannung des Hall-Sensors 2 größer V14 ist, anhand der jeweiligen, analogen Hall-Spannung das Ansteuersignal berechnet, und zwar für die Vorwärtsrichtung aus

(Hall-Spannung des Hall-Sensors 1 - V3) / (V01 - V03)*Vmax, wobei Vmax der der maximalen Geschwindigkeit entsprechende Hall-Spannungswert ist.

Dementsprechend wird das Ansteuersignal für die Rückwärtsrichtung errechnet gemäß

$$(V14 - \text{Hall-Spannung des Hall-Sensors 2}) / (V14 – V12) \times V_{max}.$$

Nachdem der aktuelle Ansteuerwert ermittelt wurde, wird er mit dem Wert Vmax verglichen und, sollte der aktuelle Wert größer sein, auf Vmax begrenzt.

Versuche haben gezeigt, dass bei der beschriebenen Ausführungsform die folgenden Spannungswerte besonders geeignet sind:

V03 = 2,336V
V04 = 1,755V
V13 = 3,33V
V14 = 2,786V

Es versteht sich, dass bei anderen Ausführungsformen des erfindungsgemäßen Fahrschalters andere Spannungswerte notwendig sein können.

Als Standardwerte für die weiteren Parameter haben sich als geeignet erwiesen:

V01 = 4,140V
V02 = 0,327V
V11 = 4,526V
V12 = 1,300V

Diese Werte können jedoch geändert und in der Datenverarbeitungseinrichtung gespeichert werden, und zwar in den folgenden drei Schritten:

1. Maximale Auslenkung des Magnetträgers in positive Richtung und Abspeichern der gemessenen Hall-Spannungen des Hall-Sensors 1 als V01 und des Hall-Sensors 2 als V11

2. Maximale Auslenkung des Magnetträgers im negativen Drehsinne und Speichern der gemessenen Hall-Spannungen des Hall-Sensors 1 als V02 und des Hall-Sensors 2 als V12

3. Abspeichern der geänderten Werte in einem Permanentspeicher der Datenverarbeitungseinrichtung

**Patentansprüche**

1. Fahrschalter zur Steuerung des Fahrantriebs eines kraftgetriebenen Flurförderzeugs,
   mit zwei Hall-Sensoren (1, 2), die einen seitlichen Abstand voneinander aufweisen,
   mit einer Quelle magnetischer Feldlinien, die bei Betätigung des Fahrschalters relativ zu den Hall-Sensoren (1, 2) verlagerbar ist, so dass sich die magnetische Flussdichte in den Hall-Sensoren (1, 2) ändert,
   **dadurch gekennzeichnet, dass** der Fahrschalter eine Datenverarbeitungseinrichtung umfasst, welche die von den Hall-Sensoren (1, 2) erzeugten, elektrischen Signale aufnimmt und den Signalen eine Fahrgeschwindigkeit und Fahrtrichtung zuordnet, wobei zur Bestimmung der Fahrgeschwindigkeit das Signal eines Hall-Sensors Verwendung findet, bei welchem sich die magnetische Flussdichte in einem Bereich befindet, in dem das elektrische Signal eine Funktion der magnetischen Flussdichte ist,
   wobei von der Datenverarbeitungseinrichtung die Hall-Spannungen der Hall-Sensoren (1, 2) analog zur Ansteuerung des Motors des Flurförderzeugs im Sinne der Vorgabe der Sollgeschwindigkeit verwendet werden, wobei der Motor des Flurförderzeugs stillgesetzt wird, wenn die Hall-Spannungswerte über gewisse Fehlertoleranzen hinaus nicht den zu erwartenden Sollwerten entsprechen.

2. Fahrschalter nach Anspruch 1, **dadurch gekennzeichnet, dass** die Hall-Sensoren (1, 2) auf einer Seite einer Platine (4) flach angeordnet sind.

3. Fahrschalter nach Anspruch 2, **dadurch gekennzeichnet, dass** auf der den Hall-Sensoren (1, 2) gegenüberliegenden Seite der Platine (4) ein Joch (7) zum Leiten der magnetischen Feldlinien vorgesehen ist.

4. Fahrschalter nach einem der Ansprüche 1 bis 3, **dadurch gekennzeichnet, dass** die Quelle magnetischer Feldlinien zwei in einem seitlichen Abstand voneinander angeordnete Permanentmagnete (3, 6) umfasst.

5. Fahrschalter nach Anspruch 4, **dadurch gekennzeichnet, dass** die Permanentmagnete (3, 6) oberhalb der Hall-Sensoren (1, 2) angeordnet sind, eine umgekehrte Polarität aufweisen, wobei sich die Polachsen etwa senkrecht zu der Platine (4) erstrecken, und in einer zur Platine (4) etwa parallelen Ebene bei Betätigung des Fahrschalters verlagerbar sind.

6. Fahrschalter nach Anspruch 5, **dadurch gekennzeichnet, dass** die Permanentmagnete (3, 6) auf ihrer der Platine (4) fortweisenden Seite über ein Joch (5) zum Leiten der magnetischen Feldlinien verbunden sind.

7. Fahrschalter nach Anspruch 5 oder 6, **dadurch gekennzeichnet, dass** die Permanentmagnete (3, 6) auf einer Kreisbahn verlagerbar sind.

8. Fahrschalter nach einem der Ansprüche 1 bis 7, **dadurch gekennzeichnet, dass** eine Speicheranordnung vorgesehen ist, in welcher die zu erwartenden Sollwerte für die elektrischen Signale der Hall-Sensoren (1, 2) in Abhängigkeit der Fahrschalterstellung gespeichert sind und dass eine Einrichtung zum Vergleich der Sollwerte mit den von den Hall-Sensoren (1, 2) erzeugten Istwerten vergleicht und bei einem nicht zu erwartenden Verhältnis der Istwert der Signale der beiden Hall-Sensoren (1, 2) den Fahrschalterzustand "neutral" bewirkt.

9. Fahrschalter nach Anspruch 8, **dadurch gekennzeichnet, dass** die Einrichtung zum Vergleich der Soll- und Istwerte derart ausgebildet ist, dass sie den Fahrschalterzustand "neutral" bewirkt, wenn die Istwerte das für die Neutralstellung zu erwartende Signalverhältnis aufweisen.

## Claims

1. A drive switch for controlling the propulsion device of a motorized industrial truck, comprising two Hall effect sensors (1, 2) that exhibit a lateral distance from one another, comprising a source of magnetic field lines that can be moved relative to the Hall effect sensors (1, 2) when actuating the drive switch so that the magnetic flux density of the Hall effect sensors (1, 2) changes,
characterized in that the drive switch includes a data processing device that receives the electric signals generated by the Hall effect sensors (1, 2) and which allocates to the signals a traveling speed and traveling direction, wherein the signal of one of the Hall effect sensors is used to determine traveling speed for which the magnetic flux density is within a range in which the electric signal is a function of the magnetic flux density,
wherein the data processing device utilizes the Hall voltages of the Hall effect sensors (1, 2) analogously to the controlling of the propulsion device of the industrial truck in terms of setting the target velocity, wherein the propulsion device of the industrial truck is shut down if the Hall voltages do not comply with the expected target values beyond certain error tolerances.

2. The drive switch of claim 1, characterized in that the Hall effect sensors (1, 2) are arranged on a plane level on one side of a circuit board (4).

3. The drive switch of claim 2, characterized in that a yoke (7) is envisaged on the side of the circuit board (4) that is opposite the Hall effect sensors (1, 2) for conducting the magnetic field lines.

4. The drive switch of any one of the claims 1 through 3, characterized in that the source of the magnetic field lines includes two permanent magnets (3, 6) laterally arranged at a lateral distance from one another to one another.

5. The drive switch of claim 4, characterized in that the permanent magnets (3, 6) are positioned above the Hall effect sensors (1, 2) that have a reversed polarity whereby their polar axes running vertically to the circuit board (4) and which can be moved on a plane parallel to the circuit board (4) when the drive switch is operated.

6. The drive switch of claim 5, characterized in that the permanent magnets (3, 6) on their side that is facing away from the circuit board (4) are connected by a yoke (5) for conducting the magnetic field lines.

7. The drive switch of any one of claim 5 or 6, characterized in that the permanent magnets (3, 6) are moveable on a circular path.

8. The drive switch of any one of claims 1 through 7, characterized in that a storage device is provided in which the expected target values for the electric signals of the Hall effect sensors (1, 2) depending on the drive switch position are stored and that an arrangement compares the target values with the actual values generated by the Hall effect sensors (1, 2) and, in case of an unexpected relation between actual values of the signals of the two Hall effect sensors (1, 2), effects the drive switch position "neutral".

9. The drive switch of claim 8, characterized in that the storage device for comparing target and actual values are of such configuration that it effects the drive switch position "neutral" if the actual values conform to the signal configuration expected for the neutral position.

## Revendications

1. Commutateur de déplacement, destiné commander le système de propulsion d'un chariot de manutention au sol automoteur, comprenant
deux capteurs à effet Hall (1, 2) qui sont disposés à une distance latérale l'un de l'autre,
une source de lignes de champ magnétique qui, lorsque le commutateur de déplacement est actionné, peut être déplacée par rapport aux capteurs à effet Hall (1, 2), de sorte que la densité du flux magnétique dans les capteurs à effet Hall (1, 2) varie,
caractérisé en ce que le commutateur de déplacement comprend un dispositif de traitement de données qui reçoit les signaux électriques générés par les capteurs à effet Hall (1, 2) et associe aux signaux une vitesse de déplacement et une direction de déplacement, la vitesse de déplacement étant déterminée à l'aide du signal d'un capteur à effet Hall dans lequel la densité du flux magnétique est dans une plage dans laquelle le signal électrique est fonction de la densité du flux magnétique,

les tensions de Hall des capteurs à effet Hall (1, 2) étant utilisées par le dispositif de traitement de données de manière analogue à la commande du moteur du chariot de manutention au sol dans le sens de la spécification de la vitesse de consigne, le moteur du chariot de manutention au sol étant arrêté si les valeurs de tension de Hall ne correspondent pas, au-delà de certaines tolérances d'erreur, aux valeurs de consigne attendues.

**2.** Commutateur de déplacement selon la revendication 1, **caractérisé en ce que** les capteurs à effet Hall (1, 2) sont disposés à plat sur un côté d'une carte de circuit imprimé (4).

**3.** Commutateur de déplacement selon la revendication 2, **caractérisé en ce qu'**une culasse (7) destiné à guider les lignes de champ magnétique est prévue sur le côté de la platine (4) qui est opposé aux capteurs à effet Hall (1, 2).

**4.** Commutateur de déplacement selon l'une des revendications 1 à 3, **caractérisé en ce que** la source de lignes de champ magnétique comprend deux aimants permanents (3, 6) disposés à une distance latérale l'un de l'autre.

**5.** Commutateur de déplacement selon la revendication 4, **caractérisé en ce que** les aimants permanents (3, 6) sont disposés au-dessus des capteurs à effet Hall (1, 2), ont des polarités inversées, les axes des pôles s'étendant approximativement perpendiculairement à la carte de circuit imprimé (4), et peuvent être déplacés dans un plan approximativement parallèle à la carte de circuit imprimé (4) lorsque le commutateur de déplacement est activé.

**6.** Commutateur de déplacement selon la revendication 5, **caractérisé en ce que** les aimants permanents (3, 6) sont reliés sur leur côté opposé à la platine (4) par une culasse (5) destinée à guider les lignes du champ magnétique.

**7.** Commutateur de déplacement selon la revendication 5 ou 6, **caractérisé en ce que** les aimants permanents (3, 6) peuvent être déplacés sur une trajectoire circulaire.

**8.** Commutateur de déplacement selon l'une des revendications 1 à 7, **caractérisé en ce qu'**il est prévu un dispositif de mémorisation dans lequel les valeurs de consigne attendues des signaux électriques des capteurs à effet Hall (1, 2) sont mémorisées en fonction de la position du commutateur de déplacement, et **en ce qu'**un dispositif de comparaison compare les valeurs de consigne aux valeurs réelles générées par les capteurs à effet Hall (1, 2) et affecte l'état « neutre » au commutateur de déplacement si le rapport des valeurs réelles des signaux des deux capteurs à effet Hall (1, 2) est inattendu.

**9.** Commutateur de déplacement selon la revendication 8, **caractérisé en ce que** le dispositif de comparaison des valeurs de consigne et des valeurs réelles est conçu de manière à affecter l'état « neutre » au commutateur de déplacement lorsque les valeurs réelles présentent le rapport de signal attendu pour la position neutre.

Fig. 1

Fig. 2

Fig. 3

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1180473 A1
- US 6276485 B